Europäisches Patentamt

European Patent Office

Office européen des brevets

(19)

(11) Veröffentlichungsnummer: **0 232 741**
B1

(12) **EUROPÄISCHE PATENTSCHRIFT**

(45) Veröffentlichungstag der Patentschrift:
02.05.90

(51) Int. Cl.⁴: **G01R 31/02, H02H 3/04**

(21) Anmeldenummer: 87100450.3

(22) Anmeldetag: 15.01.87

(54) Schaltung zur Überwachung einer Hochspannungssicherung.

(30) Priorität: 05.02.86 DE 3603514

(43) Veröffentlichungstag der Anmeldung:
19.08.87 Patentblatt 87/34

(45) Bekanntmachung des Hinweises auf die Patenterteilung:
02.05.90 Patentblatt 90/18

(84) Benannte Vertragsstaaten:
AT BE CH DE FR IT LI NL

(56) Entgegenhaltungen:
DE-A- 2 533 182
NL-A- 7 507 046
US-A- 4 554 607

(73) Patentinhaber: Schaltbau Gesellschaft mbH,
Klausenburger Strasse 6, D-8000 München 80(DE)

(72) Erfinder: Tiefenbacher, Werner, Görzerstrasse 109,
D-8000 München 90(DE)
Erfinder: Meissl, Robert, Spechtstrasse 17,
D-8031 Eichenau(DE)

(74) Vertreter: Patentanwälte Grünecker, Kinkeldey,
Stockmair & Partner, Maximilianstrasse 58,
D-8000 München 22(DE)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Gegenstand der Erfindung ist eine Schaltung zur Überwachung einer Hochspannungssicherung mit Hilfe von Impuls-Wandlern, galvanischen Trennungen und Impuls-Gleichstrom-Wandlern sowie einer Logik.

Sicherungen in Stromkreisen mit Hochspannung, wie sie zum Beispiel im Betrieb elektrischer Bahnen vorkommen, bedürfen der Überwachung, um defekte Sicherungen schnell orten und auswechseln zu können. Zunächst würde es genügen, die Spannung an einer defekten Sicherung zu erfassen. Falls aber aus irgendeinem Grunde die Hochspannung vor der Sicherung abgeschaltet wird oder bleibt, entfällt auch die Spannung an der defekten Sicherung und es kann in der Überwachung der Irrtum entstehen, daß die Sicherung in Ordnung sei.

Der vorliegenden Erfindung liegt die Aufgabe zugrunde, eine Schaltung zur Überwachung einer Hochspannungssicherung anzugeben, bei der die Ausfallmeldung auch im spannungslosen Zustand erhalten bleibt.

Die Lösung besteht darin, daß über einen Vorwiderstand die anstehende Hochspannung und über einen weiteren Vorwiderstand die über der zu überwachenden Sicherung anstehende Spannung je einem Impuls-Wandler zuführbar, die Impulse unter galvanischer Trennung je einem Impuls-Gleichstrom-Wandler und aus diesem einer Logik zuführbar sind, die ein bistabiles Relais ansteuert, das bei über der Sicherung auftretender Spannung unter Auslösung eines Alarms und/oder einer Anzeige in die eine, einem Sicherungsdefekt entsprechende Lage und erst bei Wegfall der über der Sicherung aufgetretenen Spannung und gleichzeitigem Anstehen der Hochspannung in die andere, der Betriebsbereitschaft entsprechende Lage umkippt. Die Lösung dieser Aufgabe geht davon aus, daß in Hochspannungsschaltungen von Reisezugwagen üblicherweise Impuls-Wandler eingesetzt werden, um unter galvanischer Trennung auf der Niederspannungsseite Auswertungen vorzunehmen.

Der besondere Vorteil der erfindungsgemäßen Schaltung ist darin zu sehen, daß, wenn zur Auswechselung oder Reparatur der Sicherung die Hochspannung abgeschaltet wird und damit der Spannungsabfall an der Sicherung aufhört, die Meldung eines Sicherungsdefektes erhalten bleibt, bis auch die Hochspannung wieder eingeschaltet ist, mithin die Betriebsbereitschaft tatsächlich wieder hergestellt ist.

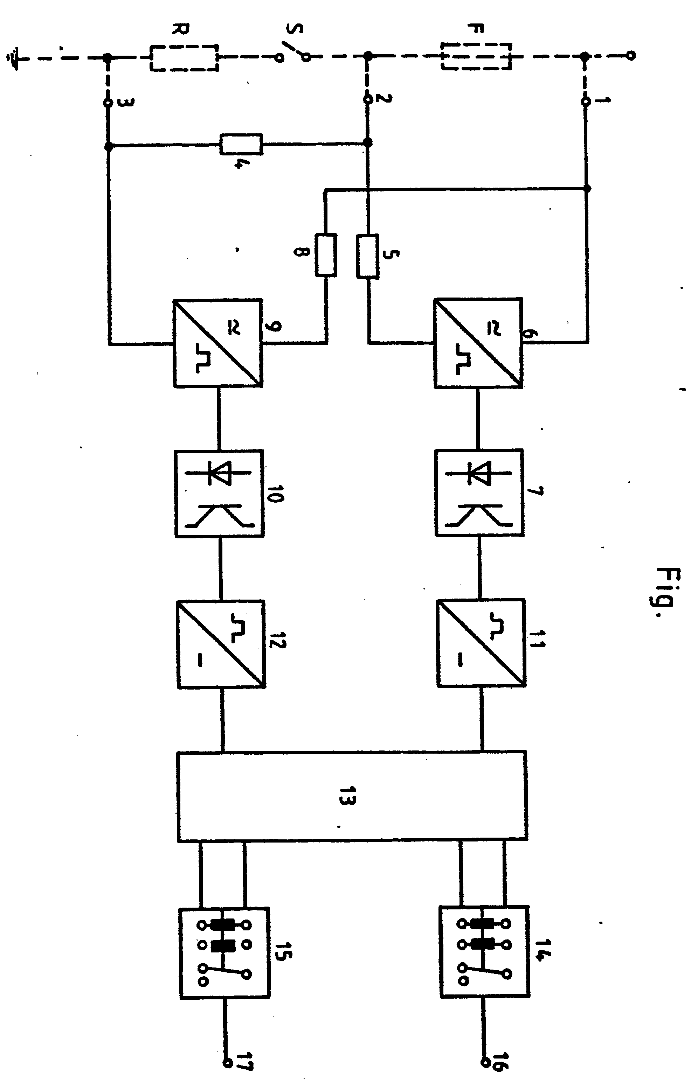

Weitere Einzelheiten und Vorteile der erfindungsgemäßen Schaltung werden an Hand der Figur erläutert. Die bei 1 und 3 anstehende Hochspannung wird über die zu überwachende Sicherung F und den Schalter S an die Last R gelegt. Über dem Vorwiderstand 8 wird die anstehende Hochspannung abgegriffen, in dem Impuls-Wandler 9 in Impulse umgesetzt und über den zur galvanischen Trennung dienenden Optokoppler 10 dem Impuls-Gleichstrom-Wandler 12 zugeführt. Das Gleichstromsignal aus 12 wird dann der Logik 13 zugeführt. Entsprechend wird über dem Vorwiderstand 5 die im Fall einer Störung der Sicherung an den Klemmen 1 und 2 auftretende Spannung abgegriffen und bei 6 in Impulse umgesetzt. Diese werden über den der galvanischen Trennung dienenden Optokoppler 7 dem Impuls-Gleichstrom-Wandler 11 zugeführt und der Gleichstrom der Logik 13 zugeleitet. Die Logik 13 steuert das bistabile Relais 14 an. Da das Ein- und Ausschalten der Hochspannung, das Durchbrennen einer Sicherung und das Einschalten der Hochspannung nach dem Sicherungswechsel dynamische Vorgänge sind, erfolgt in der Logik 13 durch Zeitverzögerung und Vorrangschaltung auch eine zeitliche Zuordnung der aus den Impuls-Gleichstrom-Wandlern 11 und 12 zugeführten Gleichstromsignale. Tritt nun durch Beschädigung oder Durchbrennen der Sicherung F über dieser ein Spannungsabfall an den Klemmen 1 und 2 auf, so steuert die Logik 13 das bistabile Relais 14 in dem Sinne an, daß dieses über den Ausgang 16 einen Alarm oder eine Anzeige betätigt. Um sicherzustellen, daß dies auch dann geschieht, wenn im Lastkreis S,R eine Unterbrechung auftritt, beispielsweise S öffnet, wird zum Lastkreis S,R ein Widerstand 4 parallel geschaltet.

Aus Sicherheitsgründen kann es erforderlich sein, das Anstehen der Hochspannung unabhängig vom Zustand der Sicherung F anzuzeigen. Zu diesem Zweck steuert die Logik 13 erfindungsgemäß ein weiteres Relais 15 an, das über den Ausgang 17 eine entsprechende Anzeige betätigt.

Es kann von Vorteil sein, auch das Relais 15 als bistabiles Relais auszubilden, um den dauernden Haltestrom dieses Relais in der gewöhnlich wärmeempfindlichen Umgebung zu vermeiden. Auch ist es möglich, für die bistabilen Relais eine manuelle Rückstellung vorzusehen.

## Patentansprüche

1. Schaltung zur Überwachung einer Hochspannungssicherung mit Hilfe von Impuls-Wandlern, galvanischen Trennungen und Impuls-Gleichstrom-Wandlern sowie einer Logik, dadurch gekennzeichnet, daß über einen Vorwiderstand (8) die anstehende Hochspannung (1,3) und über einen weiteren Vorwiderstand (5) die über der zu überwachenden Sicherung (F) anstehende Spannung (1, 2) je einem Impuls-Wandler (9, 6) zuführbar, die Impulse unter galvanischer Trennung (10, 7) je einem Impuls-Gleichstrom-Wandler (12, 11) und aus diesen einer Logik (13) zuführbar sind, die ein bistabiles Relais (14) ansteuert, das bei über der Sicherung (F) auftretender Spannung unter Auslösung eines Alarms und/oder einer Anzeige in die eine, einem Sicherungsdefekt entsprechende Lage und erst bei Wegfall der über der Sicherung (F) aufgetretenen Spannung (1, 2) und gleichzeitigem Anstehen der Hochspannung (1, 3) in die andere, der Betriebsbereitschaft entsprechende Lage umkippt.

2. Schaltung nach Anspruch 1, dadurch gekennzeichnet, daß ein Widerstand (4) parallel zu dem über die Sicherung (F) gespeisten Lastkreis (S, R) liegt und bei defekter Sicherung (F) und einer Unterbrechung im Lastkreis (S, R) das Auftreten einer Spannung (1, 2) über den Anschlüssen der Sicherung (F) sicherstellt.

3. Schaltung nach Anspruch 1 oder 2, dadurch gekennzeichnet, daß die galvanische Trennung in an sich bekannter Weise über Optokoppler vorgenommen ist.

4. Schaltung nach Anspruch 1 oder einem der folgenden, dadurch gekennzeichnet, daß von der Logik (13) ein weiteres Relais (15) ansteuerbar ist, das einen Alarm und/oder eine Anzeige für anstehende oder fehlende Hochspannung (1, 3) betätigt.

5. Schaltung nach Anspruch 4, dadurch gekennzeichnet, daß auch das weitere Relais (15) ein bistabiles Relais ist.

## Claims

1. Circuit for the monitoring of a high-voltage fuse with the aid of pulse converters, galvanic separations and pulse/direct-current converters as well as a logic, characterized in that the applied high voltage (1, 3) can be fed via a series resistor (8) and the voltage (1, 2) applied over the fuse (F) to be monitored can be fed via a further series resistor (5) in each case to a pulse converter (9, 6), the pulses can be fed with galvanic separation (10, 7) in each case to a pulse/direct-current converter (12, 11) and from the latter to a logic (13), which drives a bistable relay (14), which flips into the one position, corresponding to a fuse defect, when a voltage occurs over the fuse (F), triggering an alarm and/or an indication, and only flips into the other position, corresponding to operational readiness, when the voltage (1, 2) occurring over the fuse (F) disappears and at the same time the high voltage (1, 3) is applied.

2. Circuit according to claim 1, characterized in that a resistor (4) lies in parallel with the load circuit (S, R) fed via the fuse (F) and, in the case of a defective fuse (F) and an interruption in the load circuit (S, R), ensures the occurrence of a voltage (1, 2) over the terminals of the fuse (F).

3. Circuit according to claim 1 or 2, characterized in that the galvanic separation is performed in a way known per se via optocouplers.

4. Circuit according to claim 1 or one of the following claims, characterized in that a further relay (15), which activates an alarm and/or an indication for applied or absent high voltage (1, 3), can be driven by the logic (13).

5. Circuit according to claim 4, characterized in that the further relay (15) is also a bistable relay.

## Revendications

1. Circuit de contrôle d'un fusible à haute tension à l'aide de convertisseurs d'impulsions, de séparations galvaniques, et de convertisseurs d'impulsions en courant continu, ainsi qu'à l'aide d'une logique, circuit a caractérisé en ce que par l'intermédiaire d'une première résistance d'entrée (8) la haute tension concernée (1, 3) et la tension (1, 2) s'appliquant aux bornes du fusible (F) à contrôler sont chacune susceptibles d'être amenées respectivement à un convertisseur d'impulsions (9, 6), ces impulsions étant susceptibles d'être amenées avec séparation galvanique (10, 7) respectivement à un convertisseur impulsions-courant continu (12, 11) et à partir de celui-ci à une logique (13) qui commande un relais bistable (14) qui bascule, avec déclenchement d'une alarme et/ou d'un affichage, dans une première position correspondant à un défaut du fusible lorsqu'une tension apparait aux bornes de ce fusible (F), et qui ne bascule dans l'autre position, correspondant à la disponibilité de fonctionnement, que lorsque la tension (1, 2) apparue aux bornes du fusible (F) est supprimée et que simultanément, la haute tension (1, 3) est présente.

2. Circuit selon la revendication 1, caractérisé en ce qu'une résistance (4) est placée en parallèle sur le circuit de charge (S, R) alimenté par l'intermédiaire du fusible (F), et assure l'apparition d'une tension (1, 2) aux bornes du fusible (F) au cas d'une défectuosité de ce fusible (F) et d'une interruption dans le circuit de charge (S, R).

3. Circuit selon la revendication 1 ou la revendication 2, caractérisé en ce que la séparation galvanique est réalisée d'une façon en soi connue, par l'intermédiaire d'opto-coupleurs.

4. Circuit selon la revendication 1 ou une des suivantes, caractérisé en ce qu'un autre relais (15) est susceptible d'être commandé par la logique (13), ce relais actionnant une alarme et/ou un affichage pour signaler la présence ou l'absence de la haute tension (1, 3).

5. Circuit selon la revendication 4, caractérisé en ce que cet autre relais (15) est également un relais bistable.

Fig.